# EUROPÄISCHE PATENTANMELDUNG

(11) **EP 3 012 642 A1**
(43) Veröffentlichungstag der Anmeldung: **27.04.2016**
(21) Anmeldenummer: 15184630.0
(22) Anmeldetag: 10.09.2015
(51) Int. Cl.: G01R 31/02, G01R 31/08

(54) **VERFAHREN UND ANORDNUNG FÜR DIE ERMITTLUNG EINES FEHLERORTES BEI EINEM KURZSCHLUSS ENTLANG EINER ENERGIEVERSORGUNGSSTRECKE**

(30) Priorität: 26.09.2014 DE 102014219537
(71) Anmelder: Siemens Aktiengesellschaft, 80333 München (DE)
(72) Erfinder: BIANCHI, Roberto, 91056 Erlangen (DE); WALTHER, Jens, 90556 Cadolzburg (DE)

(57) **Zusammenfassung**

Gegenstand der vorliegenden Erfindung ist ein Verfahren für die Ermittlung eines Fehlerortes bei einem Kurzschluss entlang einer Energieversorgungsstrecke (14), umfassend die Schritte:
- Abschalten einer Energiezuleitung (6) für die Energieversorgungsstrecke (14) bei Erkennen eines Kurzschlusses an der Energieversorgungsstrecke (14);
- Zuschalten einer Prüfleitung (5) mit einem Prüfstrom für die Energieversorgungsstrecke (14), wobei der Prüfstrom derart bemessen ist, dass der Prüfstrom trotz des Kurzschlusses keinen Schaden an der Energieversorgungsstrecke (14) bewirkt;
- Bestimmen eines Leitungswiderstands der Energieversorgungsstrecke (14) bis zum Fehlerort und Ermittlung des Fehlerortes; dadurch gekennzeichnet, dass
- das Bestimmen des Leitungswiderstands mittels Messungen an der Prüfleitung (5) erfolgt.

Weiterhin ist Gegenstand der Erfindung eine Anordnung für die Ermittlung eines Fehlerortes bei einem Kurzschluss entlang einer Energieversorgungsstrecke.

## Beschreibung

Die vorliegende Erfindung betrifft ein Verfahren für die Ermittlung eines Fehlerortes bei einem Kurzschluss entlang einer Energieversorgungsstrecke gemäß dem Oberbegriff des Anspruchs 1 sowie eine Anordnung gemäß dem Oberbegriff des Anspruchs 9.

Eine Energieversorgungsstrecke kann im Sinne der Erfindung beispielsweise eine Bahnstromversorgung sein. Bei vielen Bahn- und Stromnetzbetreibern gewinnt die schnelle Lokalisierung und Beseitigung von Fehlern, z.B. durch Kurzschlüsse, zunehmend an Wichtigkeit. So genannte Schutzrelais aller Hersteller unterstützen dabei mit der Funktion "Fehlerortung". Diese Funktionalität besteht in der Lokalisierung des Fehlers in einem Wechselspannungssystem anhand der gemessenen Fehlerreaktanz bzw. des Blindwiderstands. Die gemessene Fehlerreaktanz und Fehlerdistanz, die den Fehlerort angibt, werden vom Schutzrelais in Form einer elektronischen Information dem Betreiber bereitgestellt. Diese Information wird vom Betreiber benutzt, um das Wartungspersonal sofort an die richtige Fehlerstelle zu entsenden. Dies erspart Suchzeiten und erhöht somit die Verfügbarkeit der Infrastruktur; gleichzeitig werden Kosten gespart, da das Wartungspersonal effizienter arbeiten kann. Die Fehlerortung basiert auf der Umrechnung der Fehlerreaktanz bzw. -impedanz in eine Fehlerdistanz vom Einspeisepunkt bis zum Ort des Kurzschlusses.

Aus dem Handbuch "SIPROTEC Digitaler Oberleitungsschutz für AC-Bahnstromversorgung 7ST6 V4.6", Dokumentennummer E50417-G1100-C251-A6, Ausgabedatum 09.11.2012, Seiten 156 bis 158 sowie 207 bis 208, ein Verfahren und eine Anordnung für die Ermittlung eines Fehlerortes bei einem Kurzschluss entlang einer Bahnstrecke mit einer Bahnstromversorgung bekannt. Dabei wird eine Fehlerreaktanz ermittelt und mindestens ein möglicher Fehlerort ausgegeben. Es ist üblich, die Fehlerreaktanz in dem Zeitabschnitt zwischen dem Auftreten eines Kurzschlusses und der Abschaltung der Energiezufuhr für die Bahnstromversorgung zu bestimmen. Insbesondere in 16.7 Hz Systemen der Bahnstromversorgung kann dieser Zeitabschnitt mit beispielsweise nur 20 ms bis maximal 60 ms sehr kurz sein und zu einer ungenauen Ermittlung des Fehlerortes führen. Da eine Abschaltung der Energiezufuhr für die Bahnstromversorgung in der Regel so schnell wie möglich erfolgen muss, um Schäden an der Bahnstromversorgung infolge des Kurzschlusses zu vermeiden, kann der Zeitabschnitt nicht beliebig verlängert werden. Es muss daher bei einer ungenauen Ermittlung des Fehlerortes ein Teil oder sogar die ganze Energieversorgungsstrecke manuell überprüft werden, was mit einem hohen Zeit, Personal- und Kostenaufwand verbunden ist.

Ferner werden insbesondere bei Bahnstromversorgungen so genannte Prüfkreise eingesetzt. Dabei wird eine Prüfleitung, die einen großen Prüfwiderstand aufweist, nach der Abschaltung der Energiezufuhr für die Bahnstromstromversorgung als ein paralleler Strompfad zugeschaltet. Durch den Prüfwiderstand wird der Stromfluss auch im Kurzschlussfall so stark begrenzt, dass auch bei längerer Zuschaltung des Prüfkreises, beispielsweise für mehrere Sekunden, keine Schäden an der Bahnstromversorgung entstehen. Mittels des Prüfkreises wird festgestellt, ob es sich bei dem Kurzschluss um einen transienten, also vorübergehenden Kurzschluss oder um einen permanenten Kurzschluss handelt, indem die Leitungsimpedanz gemessen wird. Insbesondere in der Bahnstromversorgung, bei der Oberleitungen zum Einsatz kommen, können transiente Kurzschlüsse beispielsweise durch Vögel ausgelöst werden. Diese transienten Kurzschlüsse können dann durch den Prüfkreis als bereits erledigt erkannt und die Energiezufuhr für die Bahnstromstromversorgung wieder zugeschaltet werden.

Das Messprinzip des Prüfkreises kann im Stand der Technik auch durch ein einzelnes Gerät bereit gestellt werden, dass alle notwenigen Komponenten wie den Prüfwiderstand in sich vereint. Es ist beispielsweise aus der Produktbeschreibung "Abzweiggebundene Prüfeinrichtung (AGP)" der Siemens AG, Revision 11 mit Stand 15.07.2009, ein solches Gerät bekannt, dass einem Leistungsschalter in einer Energiezuleitung für eine Energieversorgungsstrecke parallel geschaltet werden kann, um zu überprüfen, ob ein transienter oder ein permanenter Kurzschluss vorliegt.

An die Erfindung stellt sich die technische Aufgabe, ein Verfahren für die Ermittlung eines Fehlerortes bei einem Kurzschluss entlang einer Energieversorgungsstrecke anzugeben, mit dem vergleichsweise genau und unter Vermeidung von Schäden der Fehlerort bestimmt wird.

Die Erfindung löst diese Aufgabe durch ein Verfahren gemäß Anspruch 1.

Es ist ein Vorteil des erfindungsgemäßen Verfahrens, dass das Bestimmen des Leitungswiderstands der Energieversorgungsstrecke - nach Abschalten der Energiezuleitung wegen eines Kurzschlusses und ohne Schäden an der Bahnstromversorgung zu verursachen - beliebig lange, z.B. über mehrere Sekunden, erfolgen kann, weil der Prüfstrom wesentlich geringer ist als der Stromfluss bei einer Messung in der Energiezuleitung, die bei einem Kurzschluss möglichst umgehend abgeschaltet werden muss. Dadurch wird die Ermittlung des Fehlerortes wesentlich zuverlässiger und genauer.

Ein weiterer Vorteil ist es, das durch die Möglichkeit einer vergleichsweise langen Dauer der Bestimmung des Leitungswiderstands Kurzzeiteffekte abklingen können. Auf diese Weise wird der Widerstand jeweils in einem stabilen Zustand gemessen.

In einer bevorzugten Ausführungsform des erfindungsgemäßen Verfahrens wird der Leitungswiderstand nach einer Zeitdauer bestimmt, die länger als die Zeitdauer zwischen dem Erkennen des Kurzschlusses an der Energieversorgungsstrecke und dem Abschalten der Energiezuleitung bemessen ist. Beispielsweise beträgt die Zeitdauer mindestens 10 ms. Die Zeitdauer kann sogar mehr als eine Sekunde lang sein. Dies ist ein Vorteil, weil die Ermittlung des Fehlerortes bei einer lang andauernden Messung wesentlich genauer erfolgen kann, u. a. weil transiente Effekte abklingen können.

In einer bevorzugten Ausführungsform des erfindungsgemäßen Verfahrens wird als Energieversorgungsstrecke eine Bahnstromversorgung mit einer Oberleitung verwendet. Dies ist vorteilhaft, weil insbesondere bei Oberleitungsanlagen häufig transiente Fehler auftreten, weil beispielsweise Vögel einen Kurzschluss auslösen. Daher ist es bei Oberleitungen besonders häufig erforderlich, einen Fehlerort genau zu bestimmen.

In einer bevorzugten Ausführungsform des erfindungsgemäßen Verfahrens wird in der Prüfleitung ein Prüfwiderstand verwendet und für die Prüfleitung wird das gleiche Spannungsniveau wie für die Energiezuleitung verwendet. Dies ist ein Vorteil, weil durch den Prüfwiderstand der Prüfstrom stark begrenzt wird. Es entstehen so trotz Kurzschluss keine (weiteren) Schäden an der Energieversorgungsstrecke, obwohl das gleiche (hohe) Spannungsniveau wie für die Energiezuleitung eingesetzt wird. Ein weiterer Vorteil ist es, dass keine zweite Energiequelle für den Prüfstrom nötig ist.

In einer bevorzugten Ausführungsform des erfindungsgemäßen Verfahrens wird die Impedanz der Prüfleitung bei der Ermittlung des Fehlerortes berücksichtigt. Dies ist ein Vorteil, weil hierdurch der vergleichsweise kleine Prüfstrom in der Berechnung des Fehlerortes angemessen berücksichtigt wird.

In einer bevorzugten Ausführungsform des erfindungsgemäßen Verfahrens wird in der Prüfleitung der Prüfstrom durch eine andere Energiequelle als die Energiequelle für die Energiezuleitung erzeugt. Dies ist ein Vorteil, weil Prüfstrom und Prüfleitung unabhängig von der Energiequelle der Energiezuleitung, beispielsweise einem Hoch- oder Mittelspannungsnetz, verwendet werden können.

In einer bevorzugten Ausführungsform des erfindungsgemäßen Verfahrens wird für das Abschalten der Energiezuleitung ein Schutzgerät, das einen Leistungsschalter steuert, verwendet. Dies ist vorteilhaft, weil Schutzgeräte und angeschlossene Leistungsschalter bei Energiezuleitungen weit verbreitet sind.

In einer bevorzugten Ausführungsform des erfindungsgemäßen Verfahrens wird der ermittelte Fehlerort an ein Leitstellensystem übermittelt. Dies ist ein Vorteil, weil durch das Leitstellensystem manuell oder automatisch geeignete Maßnahmen zur Beseitigung eines Kurzschlussschadens getroffen werden können.

Ferner stellt sich an die Erfindung die technische Aufgabe, eine Anordnung für die Ermittlung eines Fehlerortes bei einem Kurzschluss entlang einer Energieversorgungsstrecke anzugeben, mit der vergleichsweise genau und unter Vermeidung von Schäden der Fehlerort bestimmbar ist.

Die Erfindung löst diese Aufgabe durch eine Anordnung gemäß Anspruch 9.

Bevorzugte und vorteilhafte Ausführungsformen der erfindungsgemäßen Anordnung ergeben sich aus den abhängigen Ansprüchen 10 bis 15.

Es ergeben sich für die erfindungsgemäße Anordnung gemäß Anspruch 9 sowie für ihre Ausführungsformen gemäß den Ansprüchen 10 bis 15 jeweils sinngemäß die gleichen Vorteile wie eingangs für das erfindungsgemäße Verfahren geschildert.

Zur besseren Erläuterung der Erfindung zeigen in schematischer Darstellung
- Figur 1: eine erste Ausführungsform einer erfindungsgemäßen Anordnung und
- Figur 2: eine zweite Ausführungsform einer erfindungsgemäßen Anordnung.

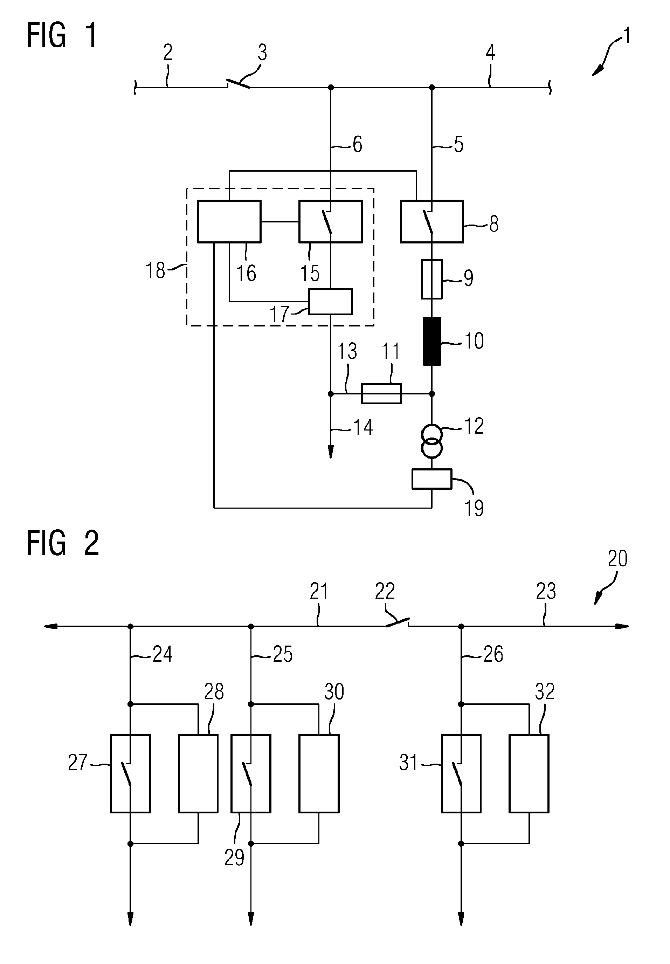

In der Figur 1 ist eine Anordnung 1 für die Ermittlung eines Fehlerortes bei einem Kurzschluss entlang einer Energieversorgungsstrecke 14 dargestellt. Ein Hochspannungsnetz 2,4 weist zwei Abschnitte 2,4 auf. Ein Leistungsschalter 3 kann den Abschnitt 2 abtrennen.

Eine Abschaltanordnung 18 zum Abschalten einer Energiezuleitung 6 für die Energieversorgungsstrecke 14 weist ein Schutzgerät 16, das einen Leistungsschalter 15 an der Energiezuleitung 6 für die Energieversorgungsstrecke 14 steuert, und eine Kurzschlussmesseinrichtung 17 auf. Wird mittels der Kurzschlussmesseinrichtung 17 ein Kurzschluss an der Energieversorgungsstrecke 14 erkannt, so schaltet das Schutzgerät 16 den Leistungsschalter 15; die Energiezuleitung 6 wird unterbrochen.

Anschließend wird durch das Schaltgerät 16 ein Schalter 8 betätigt, der eine Prüfleitung 5 zuschaltet. Die Prüfleitung ist an das gleiche Spannungsniveau angeschlossen wie die Energiezuleitung 6. Die Prüfleitung 5 ist für das Einbringen eines Prüfstrom in die Energieversorgungsstrecke im Kurzschlussfall bestimmt, wobei der Prüfstrom mittels eines Prüfwiderstands 10 so bemessen ist, dass der Prüfstrom trotz des Kurzschlusses keinen Schaden an der Energieversorgungsstrecke 14 bewirkt. Weiterhin weist die Prüfleitung 5 eine erste Sicherung 9 sowie in der Verbindung zur Energieversorgungsstrecke 14 eine zweite Sicherung 11 auf. An einem Spannungswandler 12 ist eine Messeinrichtung 19 mit einem Stromwandler (nicht dargestellt) für das Messen eines Leitungswiderstands auf der Prüfleitung angeschlossen, mittels derer der Fehlerort ermittelbar ist. Die Messeinrichtung 19 misst den Leitungswiderstand, in diesem Fall einen Blindwiderstand, unter Berücksichtigung des Prüfstromes und übermittelt den gemessenen Blindwiderstandswert an das Schutzgerät 16, das dann den Fehlerort berechnet.

Alternativ ist es möglich (nicht dargestellt), den Fehlerort direkt in der Messeinrichtung 19 zu ermitteln oder den gemessenen Blindwiderstand an ein Schutzrelais zu übertragen, das die Bestimmung des Fehlerortes vornimmt.

Die Anordnung 1 ist geeignet, den Leitungswiderstand auf der Prüfleitung 5 für eine Zeitdauer zu messen, die deutlich länger als eine Messung an der Energiezuleitung bei einem herkömmlichen Kurzschluss bemessen ist. Dies ist möglich, weil der vergleichsweise geringe Prüfstrom keine Schäden verursacht. Die Zeitdauer kann dabei sogar mehr als eine Sekunde lang sein.

In der Figur 2 ist eine stark vereinfachte Anordnung 20 dargestellt. Ein Energieversorgungsnetz 21,23, das zwei durch einen Schalter 22 getrennte Abschnitte 21,22 aufweist, ist an mehrere Energiezuleitungen 24,25,26 angeschlossen, die jeweils einen Leistungsschalter 27,29,31 aufweisen.

Parallel zu dem jeweiligen Leistungsschalter 27,29,31 ist jeweils auf einer Prüfleitung eine Anordnung 28,30,32 vorgesehen. Jede Anordnung 28,30,32 ist dabei eine kompakte Baugruppe, die jeweils die in Bezug zur Figur 1 erläuterten Baugruppen Schalter, Sicherung, Prüfwiderstand, Spannungswandler und Messeinrichtung mit Stromwandler in sich vereint. Diese Bauform ist besonders handlich und leicht zu installieren.

## Patentansprüche

1. Verfahren für die Ermittlung eines Fehlerortes bei einem Kurzschluss entlang einer Energieversorgungsstrecke (14), umfassend die Schritte:
- Abschalten einer Energiezuleitung (6) für die Energieversorgungsstrecke (14) bei Erkennen eines Kurzschlusses an der Energieversorgungsstrecke (14);
- Zuschalten einer Prüfleitung (5) mit einem Prüfstrom für die Energieversorgungsstrecke (14), wobei der Prüfstrom derart bemessen ist, dass der Prüfstrom trotz des Kurzschlusses keinen Schaden an der Energieversorgungsstrecke (14) bewirkt;
- Bestimmen eines Leitungswiderstands der Energieversorgungsstrecke (14) bis zum Fehlerort und Ermittlung des Fehlerortes;
**dadurch gekennzeichnet, dass**
- das Bestimmen des Leitungswiderstands mittels Messungen an der Prüfleitung (5) erfolgt.

2. Verfahren nach Anspruch 1, **dadurch gekennzeichnet, dass** der Leitungswiderstand nach einer Zeitdauer bestimmt wird, die länger als die Zeitdauer zwischen dem Erkennen des Kurzschlusses an der Energieversorgungsstrecke (14) und dem Abschalten der Energiezuleitung (6) bemessen ist.

3. Verfahren nach Anspruch 1 oder 2, **dadurch gekennzeichnet, dass** als Energieversorgungsstrecke (14) eine Bahnstromversorgung mit einer Oberleitung verwendet wird.

4. Verfahren nach einem der Ansprüche 1 bis 3, **dadurch gekennzeichnet, dass** in der Prüfleitung (5) ein Prüfwiderstand (10) verwendet wird und für die Prüfleitung (5) das gleiche Spannungsniveau wie für die Energiezuleitung (6) verwendet wird.

5. Verfahren nach Anspruch 4, **dadurch gekennzeichnet, dass** die Impedanz der Prüfleitung (5) bei der Ermittlung des Fehlerortes berücksichtigt wird.

6. Verfahren nach einem der Ansprüche 1 bis 3, **dadurch gekennzeichnet, dass** in der Prüfleitung (5) der Prüfstrom durch eine andere Energiequelle als die Energiequelle für die Energieversorgungsstrecke (6) erzeugt wird.

7. Verfahren nach einem der vorhergehenden Ansprüche, **dadurch gekennzeichnet, dass** für das Abschalten der Energiezuleitung (6) ein Schutzgerät (16), das einen Leistungsschalter (15) steuert, verwendet wird.

8. Verfahren nach einem der vorhergehenden Ansprüche, **dadurch gekennzeichnet, dass** der ermittelte Fehlerort an ein Leitstellensystem übermittelt wird.

9. Anordnung (1,28,30,32) für die Ermittlung eines Fehlerortes bei einem Kurzschluss entlang einer Energieversorgungsstrecke (14), aufweisend:
- eine Abschaltanordnung (18) zum Abschalten einer Energiezuleitung (6) für die Energieversorgungsstrecke (14) bei Erkennen eines Kurzschlusses an der Energieversorgungsstrecke (14) ;
- eine Prüfleitung (5) für das Einbringen eines Prüfstrom in die Energieversorgungsstrecke (14) im Kurzschlussfall, wobei der Prüfstrom so bemessen ist, dass der Prüfstrom trotz des Kurzschlusses keinen Schaden an der Energieversorgungsstrecke (14) bewirkt;
- eine Messeinrichtung (19) für das Bestimmen eines Leitungswiderstands der Energieversorgungsstrecke (14) bis zum Fehlerort, wobei mittels der Messeinrichtung (19) der Fehlerort ermittelbar ist;
**dadurch gekennzeichnet, dass**
- die Messeinrichtung (19) an der Prüfleitung (5) vorgesehen ist.

10. Anordnung (1,28,30,32) nach Anspruch 9, **dadurch gekennzeichnet, dass** die Anordnung (1,28,30,32) geeignet ist, den Leitungswiderstand nach einer Zeitdauer zu bestimmen, die länger als die Zeitdauer zwischen dem Erkennen des Kurzschlusses an der Energieversorgungsstrecke (14) und dem Abschalten der Energiezuleitung (6) bemessen ist.

11. Anordnung (1,28,30,32) nach Anspruch 9 oder 10, **dadurch gekennzeichnet, dass** die Abschaltanordnung (18) ein Schutzgerät (16), das einen Leistungsschalter (15) an der Energiezuleitung (6) für die Energieversorgungsstrecke (14) steuert, aufweist.

12. Anordnung (1,28,30,32) nach einem der Ansprüche 9 bis 11, **dadurch gekennzeichnet, dass** die Energieversorgungsstrecke (14) eine Bahnstromversorgung mit einer Oberleitung aufweist.

13. Anordnung (1,28,30,32) nach einem der Ansprüche 9 bis 12, **dadurch gekennzeichnet, dass** in der Prüfleitung (5) ein Prüfwiderstand (10) vorgesehen ist und die Prüfleitung (5) an das gleiche Spannungsniveau angeschlossen ist wie die Energiezuleitung (6).

14. Anordnung (1,28,30,32) nach Anspruch 13, **dadurch gekennzeichnet, dass** die Abschaltanordnung (18) eingerichtet ist, die Impedanz der Prüfleitung (5) bei der Ermittlung des Fehlerortes zu berücksichtigen.

15. Anordnung (1,28,30,32) nach einem der Ansprüche 9 bis 12, **dadurch gekennzeichnet, dass** die Prüfleitung (5) für die Einspeisung des Prüfstrom an eine andere Energiequelle als die Energiezuleitung (6) angeschlossen ist.
